# EUROPEAN PATENT APPLICATION

(11) **EP 4 811 491 A1**
(43) Date of publication of application: **23.09.2026**
(21) Application number: 26165176.4
(22) Date of filing: 16.03.2026
(51) Int. Cl.: H01M 10/42, B60L 50/64, G01R 31/396, H01M 10/48, H01M 50/519, H01M 50/569

(54) **BATTERY MANAGEMENT SYSTEM FOR POWER BATTERY, POWER BATTERY SYSTEM AND VEHICLE**

(30) Priority: 17.03.2025 CN 202520480754 U
(71) Applicant: Volkswagen Group (China) Technology Co., Ltd., Hefei, Anhui 230091 (CN)
(72) Inventor: ZHANG, Jing, Hefei, Anhui, 230091 (CN); ZHANG, Yufeng, Hefei, Anhui, 230091 (CN)
(74) Representative: v. Bezold & Partner Patentanwälte - PartG mbB

(57) **Abstract**

The present application relates to a battery management system (20) for a power battery (10), the battery management system comprises a data sampling unit (40) to be arranged within the power battery, the data sampling unit comprises a common flexible circuit board (70) and cell management controllers (50) integrated therein, each cell management controller (50) is configured to correspond to one or more cell modules of a plurality of cell modules of the power battery and comprises a sampling channel (56), the common flexible circuit board is formed as an elongated strip which is bendable to extend across corresponding cell modules of the plurality of cell modules (15), and the sampling channel (56) is electrically and mechanically connected to the electrode tab of the corresponding cell or to a busbar (14) electrically connected to the electrode tab by plug-in connection or fastener connection.

## Description

### Technical Field

This application relates to a battery management system for a power battery, and further relates to a power battery system comprising the battery management system and a vehicle comprising the power battery system.

### Background

Generally, a power battery system of an electric vehicle may comprise a power battery which is usually referred to as a battery pack and a battery management system for the power battery. The power battery may be composed of a large number of cells which are arranged in several cell modules, and the cells in each cell module are connected in series and/or in parallel. The battery management system may comprise a battery management controller (BMS) disposed outside of the power battery and a data sampling unit disposed within the power battery, and the data sampling unit comprises a cell management controller (CMS) for each cell module. A sampling chip of each cell management controller is usually electrically connected to an electrode tab of each cell in the cell module by a wiring harness. However, due to the large number of cells in the cell module, the wiring environment within the power battery becomes complicated, which is unfavorable for production and assembly of the power battery and may also lead to potential electromagnetic interference issues. The large number of harnesses for sampling also increase the weight of the power battery, which is not conducive to cost reduction. In addition, data aggregation and transmission between the data sampling unit provided within the power battery and the battery management controller provided outside of the power battery are usually achieved by a printed circuit board, and the printed circuit board is connected to each cell management controller of the data sampling unit and to the battery management controller by a wiring harness, which requires a large space outside of the power battery and makes the wiring environment quite complicated.

### Summary

An object of the present application is to simplify a power battery system, and in particular to simplify its battery management system.

The object is achieved by a battery management system for a power battery according to the present application. In the battery management system for a power battery, the power battery comprises a plurality of cell modules, each of the cell modules comprises a plurality of cells, and each of the cells has two electrode tabs of opposite polarities. The battery management system comprises a data sampling unit to be disposed within the power battery, the data sampling unit comprising a common flexible circuit board and cell management controllers integrated in the common flexible circuit board, each of the cell management controllers being configured to correspond to one or more than one cell module of the plurality of cell modules and comprising a sampling channel, wherein the common flexible circuit board is formed as an elongated strip which is bendable to extend across corresponding cell modules of the plurality of cell modules, and the sampling channel is electrically and mechanically connected to the electrode tab of a corresponding cell or to a busbar electrically connected to the electrode tab by plug-in connection or fastener connection.

In an embodiment, the number of the cell management controllers is equal to the number of the cell modules, and each cell management controller corresponds to one cell module.

In an embodiment, the elongated strip comprises: a main section to be fixed to the corresponding cell module and integrated with the cell management controller corresponding to the cell module, and a connecting section connecting adjacent main sections and configured to span across adjacent cell modules.

In an embodiment, the common flexible circuit board further comprises a branch section extending laterally from each of the main sections and integrated with the sampling channel.

In an embodiment, the sampling channel is a conductive trace integrated in the branch section.

In an embodiment, the battery management system further comprises a battery management controller independent of the power battery, and the battery management controller is directly connected to the data sampling unit by a flexible wiring harness.

In an embodiment, each of the cell management controllers further comprises a sampling chip, the sampling channel of the cell management controller is electrically connected with the sampling chip, and the sampling chip comprises:
a voltage sampling chip and a current sampling chip, wherein the sampling channel comprises a voltage sampling channel and a current sampling channel, and the voltage sampling channel and the current sampling channel are configured to be electrically connected to the electrode tab of the corresponding cell or the busbar electrically connected thereto; and
a temperature sampling chip, wherein the sampling channel comprises a temperature sampling channel, the temperature sampling channel is configured to be electrically connected to a temperature sensor, and the temperature sensor is attached to the electrode tab of the corresponding cell or the busbar electrically connected to the electrode tab.

In an embodiment, each of the cell management controllers further comprises at least one circuit module, and the at least one circuit module comprises: an overvoltage/undervoltage protection circuit; an equalization module; an EMC filter module; a communication module; a high-low voltage isolation module; and a power module.

In an embodiment, the sampling chip and the at least one circuit module of the cell management controller are integrated to the common flexible circuit board by surface mount technology.

In an embodiment, the cell management controllers are electrically connected with each other in series.

The application further relates to a power battery system, comprising: a power battery comprising at least one cell module, wherein each cell module comprises a plurality of cells, each cell has two electrode tabs of opposite polarities, and adjacent electrode tabs of adjacent cells are electrically connected by a busbar; and the above battery management system for a power battery, wherein the sampling channel of each of the cell management controllers is electrically connected to the electrode tab of the cell or the busbar electrically connected to the electrode tab.

The application further relates to a vehicle comprising the power battery system described as above.

The battery management system for the power battery of the present application generally comprises: the battery management controller (BMS) disposed outside of the power battery, and the data sampling unit disposed within the power battery and comprising the cell management controller (CMS) for each cell module of the power battery, where (an input port of) the battery management controller outside of the power battery and (an output port of) the data sampling unit within the power battery are directly connected by the flexible wiring harness. Such an arrangement eliminates the need for an additional printed circuit board for data transfer between the battery management controller and the cell management controller or the data sampling unit, and consequently eliminates the need for a connecting harness between the printed circuit board and each cell management controller and a connecting harness between the printed circuit board and the battery management controller. This simplifies the configuration of the power battery management system, saves space requirements, eliminates the need for the printed circuit board and the complex wiring harness associated therewith, and thereby reduces the related costs as well as all issues associated with these components, such as spatial arrangement and electromagnetic interference, etc.

Further, within the power battery, all the cell management controllers of the data sampling unit are integrated in the common flexible circuit board, forming an integral piece extending across all the cell modules of the power battery, and the common flexible circuit board not only integrates all the sampling chips and circuit modules of all the cell management controllers of all the cell modules, but also integrates all the sampling channels electrically connecting the sampling chips with the electrode tabs of all the cells in the cell modules. The power battery also no longer requires numerous and complex wiring harness within the power battery to connect the sampling chips and the cell tabs, simplifying the structure and reducing the weight of the power battery. In addition, the flexible nature of the integral flexible printed circuit board allows for flexible arrangement within each cell module and when spanning across different cell modules, making it adaptable to situations where the cell tabs extend in any direction

### Brief Description of Drawings

Exemplary embodiments of the present application will be described in detail below with reference to the accompanying drawings, and it should be understood that the embodiments described below are only used to explain the present application, rather than limiting the scope of the present application. In the accompanying drawings:
FIG. 1 is a schematic simplified block diagram of a power battery system according to an embodiment of the present application;
FIG. 2 is a part of the power battery system of FIG. 1, showing two adjacent cell modules of the power battery and corresponding parts of a data sampling unit;
FIG. 3 is a partial enlarged view of FIG. 2, showing one of the cell modules and a corresponding cell management controller; and
FIGS. 4a and 4b illustrate various different manners in which a sampling channel in a branch section of a flexible circuit board of the data sampling unit is electrically connected to a busbar in a cell module that electrically connects adjacent cells.

### Detailed Description

Exemplary embodiments of the present application are described in detail below with reference to examples. However, it should be understood by those skilled in the art that these exemplary embodiments are not intended to limit the present application. In addition, features in the embodiments of the present application can be combined with each other without conflict. For the sake of brevity, other components are omitted in the drawings, which does not imply that other components are not included in a power battery system of the present application.

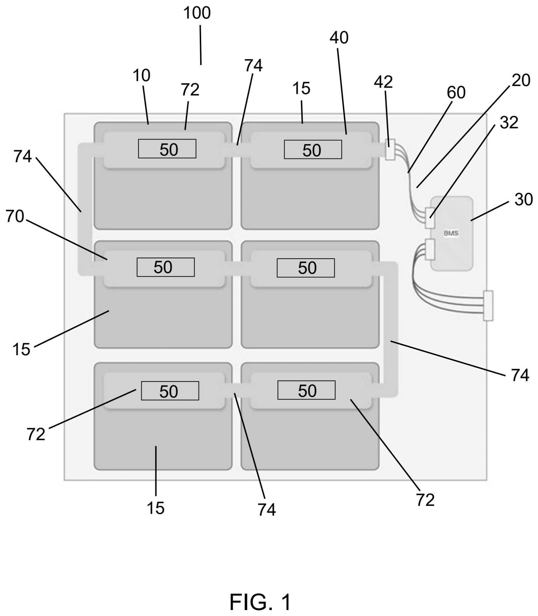

FIG. 1 shows a simplified block diagram of a configuration of a power battery system 100 for a vehicle according to an exemplary embodiment of the present application. The power battery system in this application can be applied to pure electric vehicles or hybrid vehicles.

As shown in FIG. 1, the power battery system 100 generally comprises a power battery 10 and a battery management system 20. The power battery 10 may comprise at least one, typically a plurality of cell modules 15. As shown in the exemplary embodiment of FIG. 1, the power battery 10 comprises six cell modules 15. The battery management system 20 may comprise a battery management controller 30 disposed outside of the power battery 10 and a data sampling (or acquisition) unit 40 disposed within the power battery 10, and the data sampling unit 40 may further comprise a cell management controller 50 configured for each of the cell modules 15 of the power battery 10, the cell management controllers 50 being electrically connected in series. The data sampling unit 40 and the battery management controller 30 have an output port 42 and an input port 32, respectively.

An aspect of the present application is that the output port 42 of the data sampling unit 40 and the input port 32 of the battery management controller 30 are directly connected by a flexible wiring harness 60. Therefore, as shown in FIG. 1, the battery management system 20 in this application no longer requires an additional printed circuit board to be arranged outside of the power battery 10 for data transfer between the battery management controller 30 and the data sampling unit 40 (or between the battery management controller 30 and the cell management controllers 50 of the data sampling unit 40), and therefore no longer requires a connecting harness between the printed circuit board and the data sampling unit 40 (or between the printed circuit board and the cell management controllers 50) and a connecting harness from the printed circuit board to the battery management controller 30. This eliminates the need for the printed circuit board and the complicated wiring harness associated therewith, saves costs related thereto, and eliminates any issues associated with these components such as arrangement, electromagnetic interference, etc. The configuration of the battery management system 20 and of the entire power battery system 100 is simplified, and space requirements for components other than the power battery are reduced.

Other aspects of the power battery system 100 will be described in detail below with reference to the accompanying drawings.

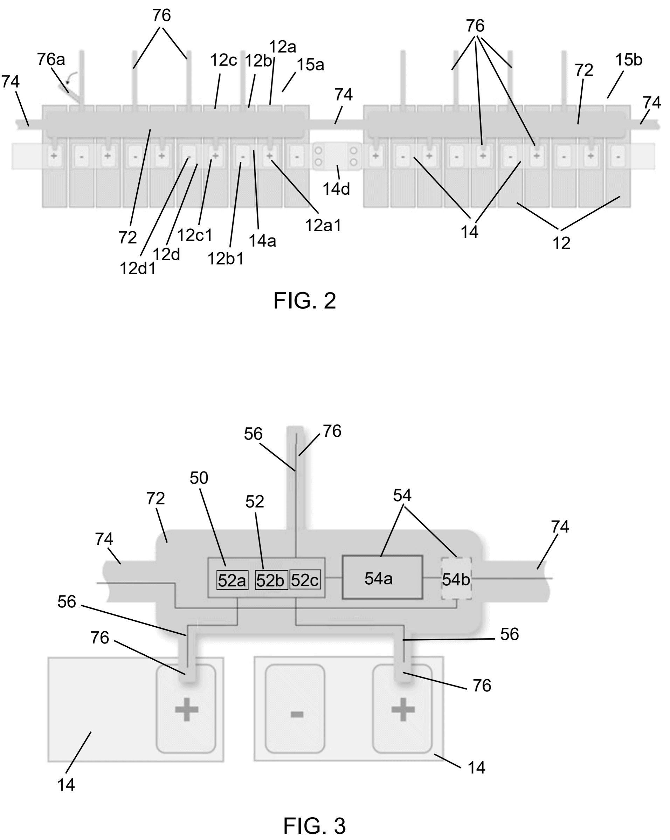

As described above, in the exemplary embodiment of FIG. 1, the power battery 10 comprises six cell modules 15. Each of the cell modules 15 may comprise a plurality of cells (or referred to as "battery cells"), and the cell is the smallest energy storage unit of the power battery and has a high energy density and may be of any type or specification known in the art. Each of the cells comprises two electrode tabs of opposite polarities, which are usually arranged on opposite sides of the cell module (as shown in FIGS. 2 and 3) or possibly arranged on top of it (relative to the cell placement as illustrated). The cells in the cell module 15 may be arranged as required, such as, connected in series, connected in parallel, or any combination thereof. In the exemplary embodiment of FIGS. 2 and 3, all the cells 12 in the cell module 15 are connected in series, and adjacent electrode tabs of opposite polarities of two adjacent cells are electrically connected with each other by a busbar 14. In particular, as shown in FIG. 2, the adjacent cells 12a and 12b are arranged in opposite orientations so that the positive electrode tab 12a1 and the negative electrode tab 12b1 are electrically connected with each other by a busbar 14a; on the opposite side in a direction perpendicular to the paper sheet which is not shown, the positive electrode tab and the negative electrode tab of the adjacent battery cells 12b and 12c which are arranged in opposite orientations are electrically connected with each other by another busbar; the positive electrode tab 12c1 of the cell 12c is electrically connected to the negative electrode tab 12d1 of the cell 12d which is adjacent to the cell 12c at a side opposite to the cell 12b by a busbar 14b, and so on. As also shown in FIG. 2, adjacent cell modules 15a and 15b are connected in series by a busbar 14d. it should be understood by those skilled in the art that the present application is not limited to the details of the power battery illustrated and described herein. For example, by changing the orientation of adjacent cells, series and/or parallel connection modes can be achieved between the cells in any of the cell modules 15 and between different cell modules 15 of the power battery 10 so as to achieve a desired total power output of the power battery 10.

As described above, the battery management controller 30 of the battery management system 20 of the power battery system is disposed outside of the power battery 10, and the data sampling unit 40 is disposed within the power battery 10, the data sampling unit 40 being configured to acquire data, such as states and parameters, of the cells 12 of the cell modules 15 of the power battery 10 and transmit the data to the battery management controller 30 by or through the flexible wiring harness 60. The battery management controller 30 is configured to monitor and manage the data, such as states and parameters, of the cells 12 of the cell modules 15 of the power battery 10 and control charging and discharging of the power battery 10. Other aspects of the battery management controller 30 are not the focus of the present application and will not be described in detail herein.

The data sampling unit 40 comprises a flexible circuit board 70 made of an insulative material, and each of the cell management controllers 50 for the cell modules 15 is integrated in the flexible circuit board 70. The flexible circuit board 70 is formed as an elongated strip to extend across all the cell modules 15 of the power battery 10, as shown schematically in FIG. 1. As a non-limiting example, the elongated strip-shaped flexible circuit board 70 may comprise a main section 72 corresponding to each of the cell modules 15. Optionally, according to the specific arrangement of the cell modules, adjacent main sections 72 corresponding to adjacent cell modules 15 may be connected by a connecting section 74, and the connecting sections may have the same or different width and/or thickness dimensions. However, the connecting section 74 is optional, not mandatory.

The cell management controller 50 disposed on each of the cell modules 15 and integrated (for example, embedded) in the corresponding main section 72 may comprise at least one sampling chip (AFE, Analog Front End) 52 and at least one circuit module 54. The sampling chip 52 is configured to be electrically connected to each of the cells 12 of the corresponding cell module 15 by a sampling channel 56 to collect or monitor data of the cells 12, such as voltage, temperature and current, and convert these analog signals into digital signals. The sampling channel 56 may be in the form of a conductive trace integrated in a branch section 76 extending laterally from the main section 72 of the flexible circuit board 70. The sampling channel 56 may be configured to be electrically connected to the electrode tab of the cell 12 or to the busbar 14 that electrically connects the adjacent electrode tabs of opposite polarities of adjacent cells.

Referring to the exemplary embodiment in FIG. 3, the sampling chip 52 may comprise, but is not limited to: a voltage sampling chip 52a, which may be electrically connected to the two electrode tabs of the cell 12 by the sampling channel 56 and may detect the voltage of the cell through an internal ADC (analog-to-digital converter); a temperature sampling chip 52b, which may be electrically connected, by the sampling channel 56, to a temperature sensor (not shown in the drawings) which is configured for measuring the temperature of the electrode tab of the cell 12, wherein the temperature sensor may be directly attached to the electrode tab of the cell or may be attached to the busbar 14 electrically connected to the electrode tab; and a current sampling chip 52c, which measures charging and discharging currents of the cell with a sampling resistor (not shown in the drawing) provided for this purpose. Examples of the circuit module 54 may comprise: an overvoltage/undervoltage protection circuit 54a configured to trigger a protection function to protect a cell from damage when a voltage of the cell exceeds a set upper limit or is lower than a set lower limit; an equalization module that integrates a MOSFET switch and a discharge resistor; an EMC filtering module, usually a low-pass filter circuit, configured to filter out voltage and temperature level ripples to ensure stability of sampling signals; a communication module 54b configured to provide a communication connection between the cell management controllers 50 corresponding to different cell modules 15; a high-low voltage isolation module configured to isolate high-voltage components of the battery management controller 30 and the cell management controller 50 from being directly connected; and the like. It should be understood by the skilled in the art that this application does not exhaustively describe all details of the sampling chip 52, the circuit module 54, and the sampling channel 56 of the cell management controller 50, but merely exemplarily lists some aspects. They will not be described in further detail in the present application. All the electrical devices (comprising, but not limited to, the sampling chip, the circuit module, the sampling channel, etc.) of the cell management controller 50 of each of the cell modules 15 may be integrated into the corresponding main section 72.

In addition, as shown in FIGS. 2 and 3, a branch section 76 is an integral part extending laterally from the main section 72 of the flexible circuit board 70. Depending on the specific arrangement of the two electrode tabs of the cell 12, the spatial layout within the cell module 15 and the spatial layout between adjacent cell modules 15, the branch section 76 may extend from two lateral sides of the corresponding main section 72 or from one of the lateral sides of the corresponding main section 72. In FIG. 2, the branch section labeled 76a indicates a portion of the branch section that is formed by bending the branch section on the opposite side of the cell after the branch section extend to that side, so as to be connected to the electrode tab on that side. Optionally, the main section 72 may have a width greater than the connecting section 74 and the branch section 76. Optionally, the entire integral flexible circuit board 70 has the same width and/or the same thickness across the whole length along its extension direction.

Depending on the actual spatial layout within each of the cell modules 15, between the cell modules 15 and within a housing of the power battery 10, the flexible circuit board 70 may be configured to be mechanically fixed or secured on some or all of the cell modules 15. As an example, each of the main sections 72 of the flexible circuit board 70 is fixed to the corresponding cell module 15 and, for example, each of the branch sections 76 of the flexible circuit board 70 is mechanically fixed and electrically connected to the electrode tab of the cell or the busbar electrically connected to the electrode tab.

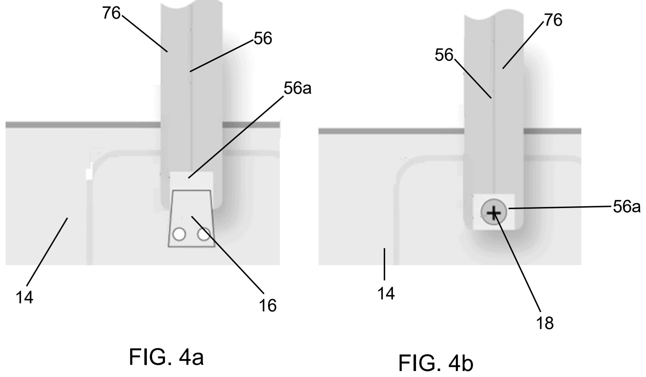

FIGS. 4a and 4b show two examples of the branch section 76 being mechanically fixed to the busbar 14. In FIG. 4a, the conductive trace (for example, a copper trace, acting as the sampling channel 56) in the branch section 76 comprises a metal endportion 56a which is exposed by removal of a portion of the insulative circuit board, and the metal endportion 56a is inserted into a space formed by a sheet or lug 16 being attached to the busbar 14 connecting the adjacent electrode tabs of opposite polarities of two adjacent cells. In this way, on one hand, the sampling channel 56, with its other end connected to the sampling chip 52, is electrically connected to the two electrode tabs of opposite polarities (which are connected with the busbar 14) of the two adjacent cells, and on the other hand, the branch section 76 is mechanically fixed to the cell module 15. In FIG. 4b, the metal endportion 56a of the conductive trace (as the sampling channel 56) of the branch section 76 is mechanically and electrically connected to the busbar 14 by means of a fastener 18, such as a screw as illustrated or a bolt or a rivet.

In FIGS. 4a and 4b, since the busbar 14 is connected to the respective electrode tabs of the two adjacent cells, the sampling channel 56 when connected to the busbar 14 is electrically connected to the electrode tabs of the two cells, and parameters such as voltage and current of the two electrode tabs (i.e., the two cells) can be collected. Provided that the temperature sensor (e.g., a temperature sensor patch) is attached to the electrode tab at the location where the busbar 14 is connected, the sampling channel 56 can be connected to the temperature sensor, achieving the collection of the temperature of the cell.

The power battery system of the present application has been described above. The battery management system of the power battery system comprises the battery management controller arranged outside of the power battery and the data sampling unit arranged within the power battery, and they are directly connected with each other by the flexible wiring harness. This eliminates the need for the printed circuit board and related wiring harness to be arranged outside of the power battery, saves the cost corresponding to the arrangement of these components, and reduces the space requirements by these components. This simplifies the configuration of the entire battery management system and reduces the weight of the entire power battery system. All the electrical devices of the data sampling unit (comprising the cell management controller for each of the cell modules) are integrated in the integral or one-piece flexible circuit board, which eliminates the need for any wiring harness to be arranged within the power battery, streamlines and simplifies the arrangement within the power battery, eliminates any technical problems related to complicated and messy wiring harness, enhances the stability of electrical connections, and reduces the space requirements of connections, material costs and time consumption of the production process.

Provided that the foregoing technical principles are satisfied, the present application is applicable to power batteries of any structure and any arrangement, and the power battery may comprise one or more cell modules each of which may comprise the same or different numbers of cells. Furthermore, due to the flexible nature of the flexible circuit board, it imposes no limitation on the orientation of the cell electrode tabs within the cell modules (for example, the electrode tabs may be disposed on the opposite sides as shown or on the top with respect to the illustrated orientation), and even less so on any other details of the cells.

Although in the illustrated embodiment, each cell management controller corresponds to one cell module, or in other words, each cell module is provided with one cell management controller, it is also contemplated in the present application that the number of cell management controllers is less than the number of cell modules. In this case, one cell management controller may correspond to more than one cell module. In this condition, the cell management controller, especially the sampling chip thereof, will be disposed on one of the more than one cell module, and the sampling channel of the cell management controller extends to and is electrically connected to the electrode tabs of each cell of each of the more than one cell module corresponding to the cell management controller. Depending on the arrangement of the cell modules (for example, in a line, or in a matrix as shown), the common flexible circuit board may be bendable to extend across the corresponding cell modules, for example, each of the cell modules on which the cell management controller is mounted.

Although it is shown that electrical and mechanical connections which enable to collect parameters or data of the cells are achieved by having the sampling channels in the branch sections of the flexible circuit board inserted (blade connection) or fastened (e.g., by the bolt, the screw, the rivet, etc.) to the busbars which are electrically connected to the cell electrode tabs, the present application is not limited to this specific connection manner. The use of detachable connection such as bolts also allows for convenient maintenance and disassembly, improving maintenance efficiency and simplifying the entire pack production process. Furthermore, it is conceivable that the flexible circuit board may have additional mechanical connection points at locations other than those where the electrical devices are integrated.

It is also conceivable that the flexible circuit board is relatively flexible in arrangement within the cell modules due to its flexible nature. For example, a portion (for example, some or all of the branch sections 76) of the flexible circuit board can be arranged or embedded near the electrode tabs (or referred to as "electrode poles") of the cells of the corresponding cell module. While ensuring that the electrical devices of the data sampling unit can be embedded therein, the flexible circuit board can be designed to be relatively thin and occupy a small space or occupy a substantially negligible space. It can be fixed to a housing of the cell module by bonding or riveting at some locations (for example, discrete locations).

Although not shown in the drawings, the skilled in the art can conceive of any possible manner of integrating the electrical devices of the data sampling unit in the flexible circuit board, and one possible example is in the form of a surface-mount package. Each cell management controller, especially its sampling chip, can be arranged to be as close to the cells in the corresponding cell module as possible, to shorten the sampling channel, reduce sampling errors, and save costs, such as material costs related to the conductive traces of the sampling channels.

The exemplary embodiments of the power battery system of the present application are described in detail as above with reference to the accompanying drawings. It should be understood by those skilled in the art that various additions, deletions and modifications may be made to the details described above and shown in the drawings without departing from the spirit and scope of the present application, all of which fall within the scope of protection of the present application.

## Claims

1. A battery management system (20) for a power battery (10), wherein the power battery comprises a plurality of cell modules (15), each of the cell modules comprises a plurality of cells (12), and each of the cells has two electrode tabs of opposite polarities, **characterized in that** the battery management system comprises:
a data sampling unit (40) to be disposed within the power battery (10), comprising a common flexible circuit board (70) and cell management controllers (50) integrated in the common flexible circuit board, each of the cell management controllers (50) being configured to correspond to one or more than one cell module of the plurality of cell modules and comprising a sampling channel (56),
wherein the common flexible circuit board (70) is formed as an elongated strip which is bendable to extend across corresponding cell modules of the plurality of cell modules (15), and the sampling channel (56) is electrically and mechanically connected to the electrode tab of the corresponding cell or to a busbar (14) electrically connected to the electrode tab by plug-in connection or fastener connection.

2. The battery management system (20) for a power battery (10) according to claim 1, **characterized in that** the number of the cell management controllers is equal to the number of the cell modules, and each cell management controller is configured to correspond to one cell module.

3. The battery management system (20) for a power battery (10) according to claim 2, **characterized in that** the elongated strip comprises: a main section (72) to be fixed to the corresponding cell module (15) and integrated with the cell management controller (50) corresponding to the cell module, and a connecting section (74) connecting adjacent main sections (72) and configured to span across adjacent cell modules.

4. The battery management system (20) for the power battery (10) according to claim 3, **characterized in that** the common flexible circuit board (70) further comprises a branch section (76) extending laterally from each of the main sections (72) and integrated with the sampling channel (56).

5. The battery management system (20) for a power battery (10) according to claim 4, **characterized in that** the sampling channel (56) is a conductive trace integrated in the branch section (76).

6. The battery management system (20) for a power battery (10) according to claim 5, **characterized in that** the battery management system further comprises a battery management controller (30) independent of the power battery, and the battery management controller (30) is directly connected to the data sampling unit (40) by a flexible wiring harness (60).

7. The battery management system (20) for a power battery (10) according to claim 6, **characterized in that** each of the cell management controllers (50) further comprises a sampling chip (52), the sampling channel of the cell management controller (50) is electrically connected with the sampling chip (52), and the sampling chip (52) comprises:
a voltage sampling chip and a current sampling chip, wherein the sampling channel comprises a voltage sampling channel and a current sampling channel, and the voltage sampling channel and the current sampling channel are configured to be electrically connected to the electrode tab of the corresponding cell or the busbar electrically connected thereto; and
a temperature sampling chip, wherein the sampling channel comprises a temperature sampling channel, the temperature sampling channel is configured to be electrically connected to a temperature sensor, and the temperature sensor is attached to the electrode tab of the corresponding cell or the busbar electrically connected to the electrode tab.

8. The battery management system (20) for a power battery (10) according to claim 7, **characterized in that** each of the cell management controllers (50) further comprises at least one circuit module, and the at least one circuit module comprises: an overvoltage/undervoltage protection circuit; an equalization module; an EMC filter module; a communication module; a high-low voltage isolation module; and a power module.

9. The battery management system (20) for a power battery (10) according to claim 8, **characterized in that** the sampling chip and the at least one circuit module of the cell management controller (50) are integrated to the common flexible circuit board (70) by surface mount technology.

10. The battery management system (20) for a power battery (10) according to any one of claims 1-9, **characterized in that** the cell management controllers (50) are electrically connected with each other in series.

11. A power battery system (100), comprising:
a power battery (10) comprising at least one cell module, wherein each cell module comprises a plurality of cells, each cell has two electrode tabs of opposite polarities, and adjacent electrode tabs of adjacent cells are electrically connected by a busbar (14); and
a battery management system (20) for a power battery (10) according to any one of claims 1-10, wherein the sampling channel (56) of each of the cell management controllers (50) is electrically connected to the electrode tab of the cell or the busbar (14) electrically connected to the electrode tab.

12. A vehicle, comprising a power battery system (100) according to claim 11.
